# EUROPÄISCHE PATENTSCHRIFT

(11) **EP 0 811 168 B1**
(45) Veröffentlichungstag und Bekanntmachung des Hinweises auf die Patenterteilung: **20.01.1999**
(21) Anmeldenummer: 96902889.3
(22) Anmeldetag: 16.02.1996
(51) Int. Cl.: G01R 15/04

(54) **SPANNUNGSWANDLER MIT ERHÖHTER SPANNUNGSFESTIGKEIT**
VOLTAGE TRANSFORMER WITH INCREASED ELECTRIC STRENGTH
TRANSFORMATEUR DE TENSION A RIGIDITE DIELECTRIQUE ACCRUE

(30) Priorität: 24.02.1995 DE 19507934
(43) Veröffentlichungstag der Anmeldung: 10.12.1997
(73) Patentinhaber: SIEMENS AKTIENGESELLSCHAFT, 80333 München (DE)
(72) Erfinder: BAUMGÄRTL, Ulrich, D-13599 Berlin (DE); RÖHL, Wolfgang, D-13503 Berlin (DE)
(86) Internationale Anmeldenummer: DE9600291
(87) Internationale Veröffentlichungsnummer: WO9626447

(56) Entgegenhaltungen:
- CH-A- 627 853
- DD-A- 134 674

## Beschreibung

Die Erfindung betrifft einen Spannungswandler mit erhöhter Spannungsfestigkeit zur Verwendung in einem mehrpoligen Niederspannungs-Leistungsschalter.

Zur normalen Ausrüstung von Niederspannungs-Leistungsschaltern gehören Stromwandler, welche die Eingangssignale für einen Überstromauslöser bereitstellen. Jedoch kann zusätzlich die Aufgabe bestehen, die Spannung am Ort des Leistungsschalters zu messen, um beispielsweise eine Leistungsmessung vorzunehmen oder die Netzspannung anzeigen zu können.

An sich ist diese Aufgabe mit Hilfe der bekannten induktiven Spannungswandler zu erfüllen. Es besteht jedoch die Forderung, daß bei der vorgeschriebenen Hochspannungsprüfung eines Niederspannungs-Leistungsschalters mit z. B. 3,5 kV auch Spannungswandler einzubeziehen sind, wenn diese im Betrieb angeschlossen sind. Induktive Spannungswandler, die für eine derart hohe Prüfspannung bemessen sind, stellen jedoch eine aufwendige Sonderausführung dar, die dem Wunsch nach geringer Baugröße und Preis nicht entspricht.

Gewöhnliche Transformatoren, wie sie etwa zur Stromversorgung von Unterspannungsauslösern verwendet werden (DE-Buch "Niederspannungs-Leistungsschalter", Springer-Verlag 1970, Seiten 135 bis 137), eignen sich weder aufgrund ihrer Eigenschaften noch ihrer Baugröße für den vorliegenden Zweck.

Es ist auch bereits ein kapazitiv arbeitender Spannungswandler für eine metallgekapselte Hochspannungsanlage bekannt, der einen kapazitiven Teiler und eine Verstärkerschaltung mit Operationsverstärkern umfaßt (CH 627 853 A5). Dieses Meßprinzip ist bei einem Niederspannungs-Leistungsschalter nicht anwendbar, da hier mittels eines kapazitiven Teilers kein brauchbares Meßsignal zu gewinnen ist.

Es ist ferner bekannt, zur Spannungsmessung ohmsche Spannungsteilerwiderstände einzusetzen, die mit Abschirmungen versehen sind und in Verbindung mit Operationsverstärkern eine Spannungsmessung mit vermindertem frequenzabhängigem Fehler und vermindertem Einfluß äußerer Störfelder ermöglichen (DD-PS 134 674).

Der Erfindung liegt die Aufgabe zugrunde, einen Spannungswandler mit erhöhter Spannungsfestigkeit zum Einsatz in einem mehrpoligen Niederspannungs-Leistungsschalter zu schaffen, der unempfindlich gegen Einstreuungen ist und der bei geringer Baugröße preiswert herstellbar ist.

Diese Aufgabe wird gemäß der Erfindung dadurch gelöst, daß in jedem Pol einem Widerstandsteiler aus ohmschen Widerständen mit der geforderten Spannungsfestigkeit ein Operationsverstärker nachgeschaltet ist, an dessen Ausgang die Primärwicklung eines induktiven Übertragers angeschlossen ist, dessen Sekundärwicklung die Unterspannungsseite des Spannungswandlers bildet und daß zur Bildung eines künstlichen Sternpunktes die einen Enden der Sekundärwicklungen der induktiven Übertrager miteinander direkt verbunden und die anderen Enden der Sekundärwicklungen über je einen Widerstand miteinander verbunden sind und daß zwischen die Sekundärwicklungen und eine Meßeinrichtung je ein Impedanzwandler geschaltet ist, wobei der künstliche Sternpunkt als Bezugspotential mit der Meßeinrichtung verbunden ist.Der Vorteil eine solchen Spannungswandlers gegenüber den bekannten induktiven Spannungswandlern besteht darin, daß Widerstände mit der geforderten Spannungsfestigkeit preiswert erhältlich sind. Die vorgesehenen induktiven Übertrager sind gleichfalls preiswerte Bauelemente, weil sie der Unterspannungsseite des Spannungswandlers zugeordnet sind und nur die Aufgabe der galvanischen Trennung zwischen dem Spannungsteiler und der Ausgangsseite haben. Der künstliche Sternpunkt verringert Meßfehler durch eingestreute Störspannungen, wenn der Spannungswandler an einem Netz ohne Neutralleiter betrieben wird und der aus den Widerständen gebildete Eingangskreis sehr hochohmig ist. Nach einer Weiterbildung der Erfindung können solche Einstreuungen ("Brummen") dadurch unwirksam gemacht werden.

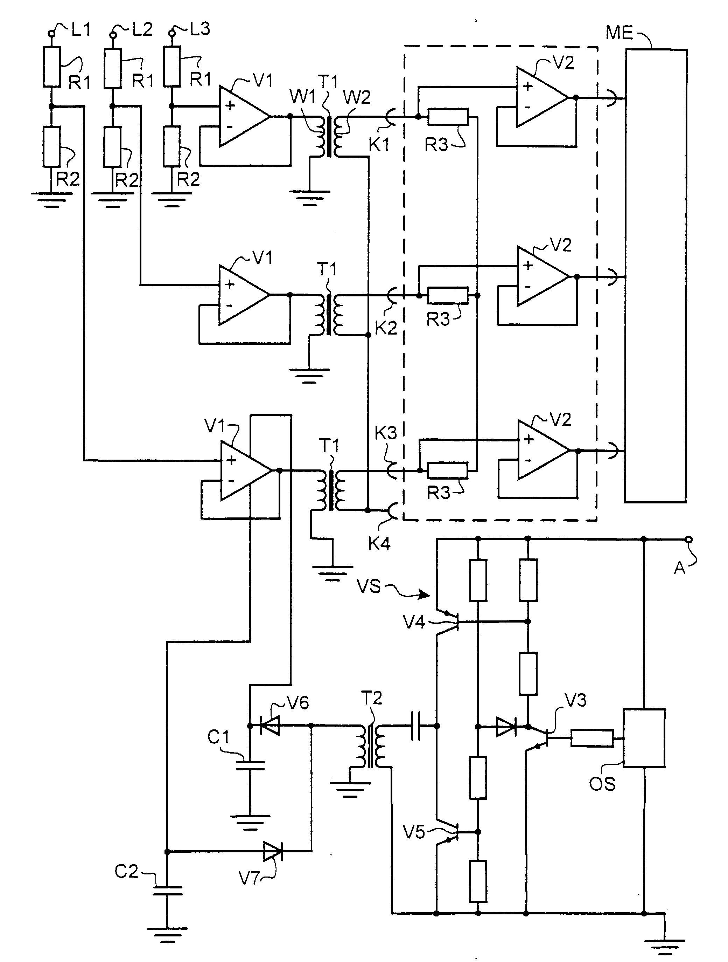

Die Erfindung wird im folgenden anhand des in der Figur gezeigten Ausführungsbeispieles näher erläutert.

An jeden Phasenleiter des Netzes L1, L2 und L3 ist ein ohmscher Spannungsteiler angeschlossen, der aus einem ersten Widerstand R1 und einem zweiten Widerstand R2 besteht. Beispielsweise können die Widerstände R1 einen Widerstandswert von 4 MΩ aufweisen, während die Widerstände R2 einen Widerstandswert von 40 kΩ besitzen. Am Verbindungspunkt der Widerstände R1 und R2 ist die anliegende Netzspannung somit im Verhältnis 1:100 geteilt. Bei den Widerständen R1 handelt es sich um eine ausreichend spannungsfeste Ausführung, wobei zur Erhöhung der Spannungsfestigkeit auch eine Reihenschaltung mehrerer Widerstände mit entsprechend geringerem Widerstandswert vorgesehen sein kann. Die an den Verbindungspunkten der Widerstände R1 und R2 anliegenden Spannungen werden jeweils einem Operationsverstärker V1 zugeführt, dessen Ausgang die Primärwicklung W1 eines induktiven Übertragers T speist. Die Anschlußpunkte K1, K2, K3 und K4 bilden den Ausgang des Spannungswandlers. Eine Meßeinrichtung ME ist zur Verbindung mit den Anschlußpunkten K1, K2, K3 und K4 mit entsprechenden Kontakten versehen.

Die Messung kann durch eingestreute Störspannungen erschwert sein, wenn der Spannungswandler an einem Netz ohne Neutralleiter betrieben wird und der aus den Widerständen gebildete Eingangskreis sehr hochohmig ist. Nach-der Erfindung werden solche Einstreuungen ("Brummen") dadurch unwirksam gemacht, daß zur Bildung eines künstlichen Sternpunktes die einen Enden der Sekundärwicklungen W2 der induktiven Übertrager T1 miteinander direkt verbunden und die anderen Enden der Sekundärwicklungen W2 über je einen Widerstand R3 miteinander verbunden sind und daß zwischen die Sekundärwicklungen W2 und eine Meßeinrichtung je ein als Impedanzwandler arbeitender Operationsverstärker V2 geschaltet ist. Die Meßeinrichtung ME erhält ein Bezugspotential durch eine Verbindung mit dem künstlichen Sternpunkt der Widerstände R3.

Eine aus den Widerständen R3 und den Operationsverstärkern V2 gebildete Baugruppe kann als Zusatzgerät ausgebildet sein, das bei Bedarf zwischen die Anschlußpunkte K1, K2, K3 und K4 und die Meßeinrichtung ME einzufügen ist. Dies ist in der Figur durch eine strichpunktierte Umrandung der genannten Bauelemente dargestellt.

Zum Betrieb des beschriebenen Spannungswandlers wird nur eine geringe Hilfsenergie benötigt. Diese steht in der Regel in einem Niederspannungs-Leistungsschalter insbesondere zum Betrieb des elektronischen Überstromausläsers zur Verfügung. Zur Anpassung an den beschriebenen Spannungswandler kann eine im unteren Teil der Figur gezeigte Versorgungsschaltung VS dienen, die ausgehend von einem Anschlußpunkt A einen Osszillator OS sowie Transistoren V3, V4 und V5 sowie einen Transformator T2 aufweist. Dioden V6 und V7 sowie Kondensatoren C1 und C2 richten den Wechselstrom am Ausgang des Transformators T2 gleich und glätten die Welligkeit.

In dem gezeigten Schaltbild ist nur der untere der Operationsverstärker V1 mit der Versorgungsschaltung VS verbunden dargestellt. Die übrigen Operationsverstärker V1 und auch die Operationsverstärker V2 können in gleicher Weise aus der Versorgungsschaltung VS betrieben werden.

## Patentansprüche

1. Spannungswandler mit erhöhter Spannungsfestigkeit zur Verwendung in einem mehrpoligen Niederspannungs-Leistungsschalter,
**dadurch gekennzeichnet,** daß in jedem Pol einem Widerstandsteiler aus ohmschen Widerständen (R1, R2) mit der geforderten Spannungsfestigkeit ein Operationsverstärker (V1) nachgeschaltet ist, an dessen Ausgang die Primärwicklung (W1) eines induktiven Übertragers (T1) angeschlossen ist, dessen Sekundärwicklung (W2) die Unterspannungsseite des Spannungswandlers bildet, und daß zur Bildung eines künstlichen Sternpunktes die einen Enden der Sekundärwicklungen (W2) der induktiven Übertrager (T1) miteinander direkt verbunden und die anderen Enden der Sekundärwicklungen (W2) über je einen Widerstand (R3) miteinander verbunden sind und daß zwischen die Sekundärwicklungen (W2) und eine Meßeinrichtung (ME) je ein Impedanzwandler (V2) geschaltet ist, wobei der künstliche Sternpunkt als Bezugspotential mit der Meßeinrichtung (ME) verbunden ist.

## Claims

1. Voltage transformer having an increased voltage strength for use in a multipole low-voltage power circuit-breaker, characterized in that, in each pole, an operational amplifier (V1) is connected downstream of a resistor divider formed by non-reactive resistors (R1, R2) having the required voltage strength, to the output of which operational amplifier (V1) is connected the primary winding (Wl) of an inductive transformer (T1), the secondary winding (W2) of which forms the undervoltage side of the voltage transformer, and in that, in order to form an artificial neutral point, the one ends of the secondary windings (W2) of the inductive transformers (T1) are connected directly to one another and the other ends of the secondary windings (W2) are connected to one another via a respective resistor (R3), and in that a respective impedance converter (V2) is connected between the secondary windings (W2) and a measuring device (ME), the artificial neutral point being connected as reference potential to the measuring device (ME).

## Revendications

1. Transformateur de tension à rigidité diélectrique accrue pour l'utilisation dans un disjoncteur basse tension multipôle, caractérisé en ce que, dans chaque pôle, il est monté en aval d'un diviseur à résistance constitué de résistances (R1, R2) ohmiques ayant la rigidité diélectrique exigée un amplificateur (V1) opérationnel à la sortie duquel est raccordé l'enroulement (W1) primaire d'un translateur (T1) inductif dont l'enroulement (W2) secondaire forme le côté à minimum de tension du transformateur de tension, et en ce que, pour former un point neutre artificiel, des extrémités des enroulements (W2) secondaires des translateurs (T1) inductifs sont reliées directement entre elles et les autres extrémités des enroulements (W2) secondaires sont reliées entre elles chacune par l'intermédiaire d'une résistance (R3), et en ce qu'il est branché entre les enroulements (W2) secondaires et un dispositif (ME) de mesure chaque fois un transformateur (V2) d'impédance, le point neutre artificiel servant de potentiel de référence étant relié au dispositif (ME) de mesure.
